# FASCICULE DE BREVET EUROPEEN

(11) **EP 1 168 179 B1**
(45) Date de publication et mention de la délivrance du brevet: **13.08.2003**
(21) Numéro de dépôt: 01410078.8
(22) Date de dépôt: 29.06.2001
(51) Int. Cl.: G06F 11/20

(54) **Circuit de mémoire dynamique comportant des cellules de secours**
Dynamischer Speicher mit redundanten Zellen
Dynamic memory with spare cells

(30) Priorité: 30.06.2000 FR 0008498
(43) Date de publication de la demande: 02.01.2002
(73) Titulaire: STMicroelectronics S.A., 92120 Montrouge (FR)
(72) Inventeur: Ferrant, Richard, 38920 Crolles (FR)
(74) Mandataire: de Beaumont, Michel

(56) Documents cités:
- US-A- 4 608 666
- AKIRA TANABE ET AL: "A 30-NS 64-MB DRAM WITH BUILT-IN SELF-TEST AND SELF-REPAIR FUNCTION" IEEE JOURNAL OF SOLID-STATE CIRCUITS,US,IEEE INC. NEW YORK, vol. 27, no. 11, 1 novembre 1992 (1992-11-01), pages 1525-1531, XP000320438 ISSN: 0018-9200
- PATENT ABSTRACTS OF JAPAN vol. 005, no. 073 (P-061), 15 mai 1981 (1981-05-15) & JP 56 019595 A (FUJITSU LTD), 24 février 1981 (1981-02-24)

## Description

La présente invention concerne les mémoires dynamiques (DRAM) et plus particulièrement les mémoires dynamiques munies de structures de secours permettant le remplacement de cellules défectueuses.

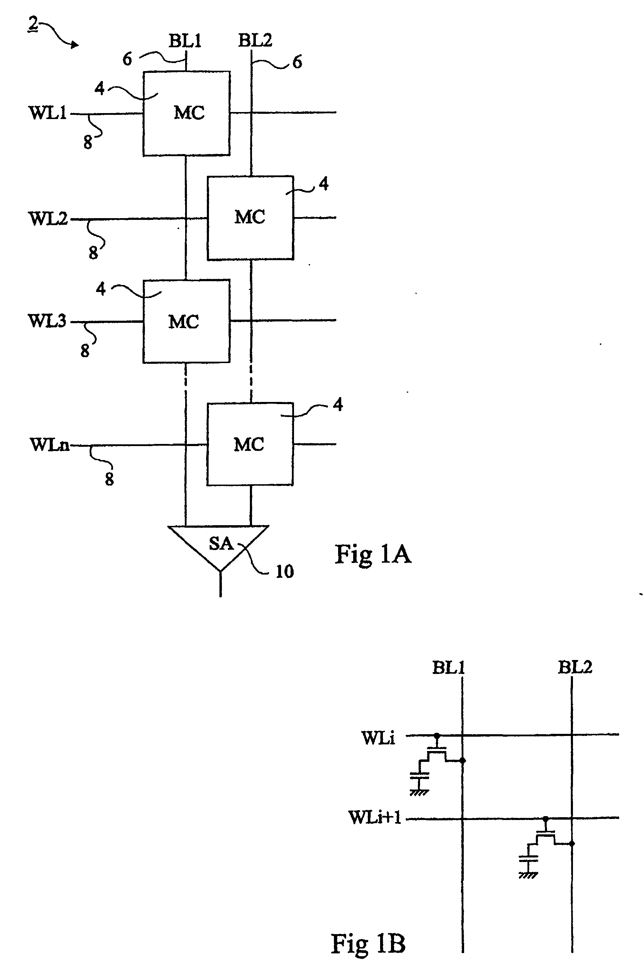

La figure 1A représente de manière schématique une architecture classique de mémoire dynamique 2 organisée en rangées et en colonnes de cellules mémoire 4 (MC). Chaque cellule 4 (MC) est reliée à une ligne de bit 6 et à une ligne de mot 8 (WLi), i allant de 1 à n, n étant le nombre de rangées mémoire. Chaque colonne de cellules mémoire comprend deux lignes de bit 6 (BL1, BL2). Les cellules mémoire de chaque colonne sont disposées de manière alternée, les cellules des rangées impaires et paires étant accessibles respectivement par des première et seconde lignes de bit BL1 et BL2. L'allure d'une cellule, comprenant une capacité dont une borne est reliée à la masse et une borne est connectée à une ligne de bit par l'intermédiaire d'un transistor activable par une ligne de mot est illustrée en figure 1B. Un décodeur d'adresse de rangée (non représenté) est prévu pour recevoir une adresse et fournir un signal d'activation sur la ligne de mot WLi correspondante. Un amplificateur de lecture 10 (SA) a ses deux entrées connectées respectivement aux deux lignes de bit BL1 et BL2. Pour des raisons de clarté, seules deux lignes de bit et n rangées de la mémoire 2 ont été représentées en figure 1A.

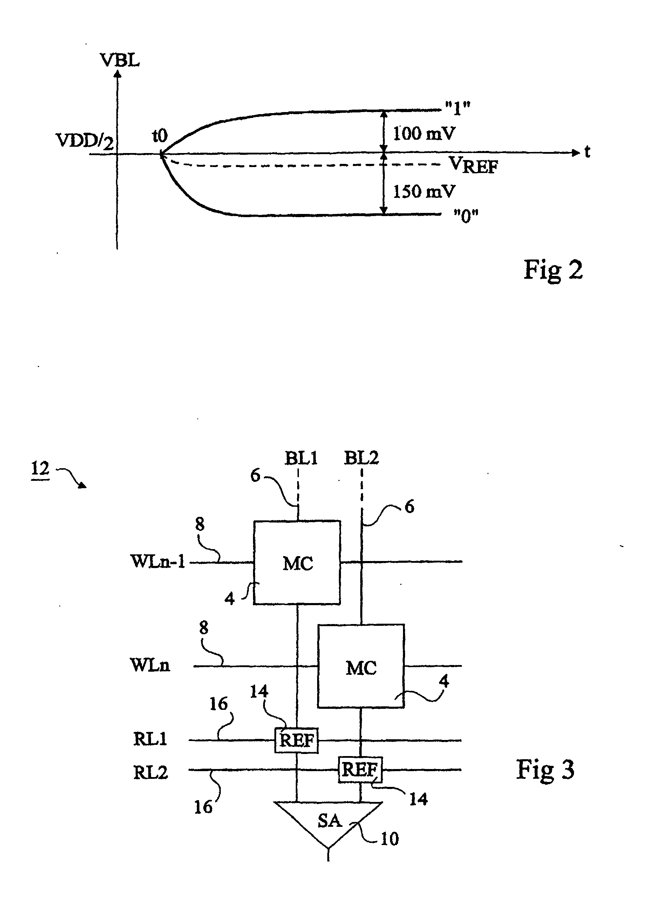

Une opération d'écriture/lecture dans une telle mémoire comprend la succession d'étapes suivante. On commence par écrire dans chacune des cellules MC l'information que l'on veut y mémoriser. Cette écriture consiste, par un adressage de la cellule choisie et une connexion convenable de la ligne de bit correspondante à écrire dans chaque cellule une tension haute ou une tension basse. La tension basse correspond sensiblement à la tension de la masse et la tension haute est proche de la tension d'alimentation VDD. Toutefois, en pratique, la tension haute sera inévitablement inférieure à la tension VDD et de plus tend à baisser au cours du temps. C'est pourquoi on prévoit en outre un rafraîchissement périodique des cellules mémoire. Avant chaque opération de lecture, on procède à une opération de précharge des lignes de bit, c'est-à-dire qu'une certaine tension, couramment VDD/2, est appliquée à chaque ligne de bit et est stockée sur la capacité de cette ligne. Lors d'une opération de lecture proprement dite, telle qu'illustrée en figure 2, à un instant t0, on adresse une cellule mémoire et la tension VDD/2 existant initialement sur la ligne de bits est amenée à monter si la cellule mémoire concernée a mémorisé un "1" (tension haute) et à descendre si la cellule mémoire concernée a mémorisé un "0" (tension basse), et l'amplificateur différentiel 10 mesure la différence entre cette tension surélevée ou cette tension abaissée et la tension VDD/2. Toutefois, en raison de la dissymétrie des opérations de charge d'un "1" et d'un "0", la différence entre les deux entrées de l'amplificateur opérationnel sera plus faible dans le cas où l'on a mémorisé un "1" que dans le cas où l'on a mémorisé un "0". Cette différence sera par exemple, comme l'indique la figure 2, de l'ordre de 100 millivolts pour la mémorisation d'un "1" et de l'ordre de 150 millivolts pour la mémorisation d'un "0". Pour résoudre ce problème, on modifie en général la tension reçue par l'entrée de l'amplificateur 10 qui n'est pas reliée à la cellule mémoire lue pour la faire passer à une valeur V_{REF} inférieure à VDD/2, de sorte que, comme cela est illustré en figure 2, la différence entre la tension V_{REF} et une tension haute lue est sensiblement la même que la différence entre la tension V_{REF} et une tension basse lue.

La figure 3 représente de manière schématique une mémoire dynamique 12 classique, semblable à la mémoire 2 de la figure 1, dont chaque ligne de bit est en outre connectée à une cellule 14 d'ajustement de tension (REF). Chacune des cellules 14 est activée pour amener la ligne à laquelle elle est connectée à la valeur V_{REF} définie précédemment au début d'une phase de lecture d'une ligne adjacente. Les cellules 14 sont reliées par des lignes d'activation 16 (RL1, RL2) au décodeur d'adresse de rangée (non représenté). La structure des cellules 14 d'ajustement de tension, connue, ne sera pas détaillée ici.

En outre, les mémoires DRAM classiques comme celles décrites en figures 1 ou 3 se heurtent à d'autres problèmes. En effet, les lignes de bit sont en général relativement longues et très proches les unes des autres. Ainsi, lorsqu'on lit simultanément deux lignes de bit, la tension présente sur la première ligne de bit peut influer sur la tension de la seconde ligne de bit et perturber sa lecture. Une solution à ce problème consiste à faire subir un ou plusieurs croisements à chaque couple de lignes de bit, comme cela est représenté de manière schématique en figure 4A.

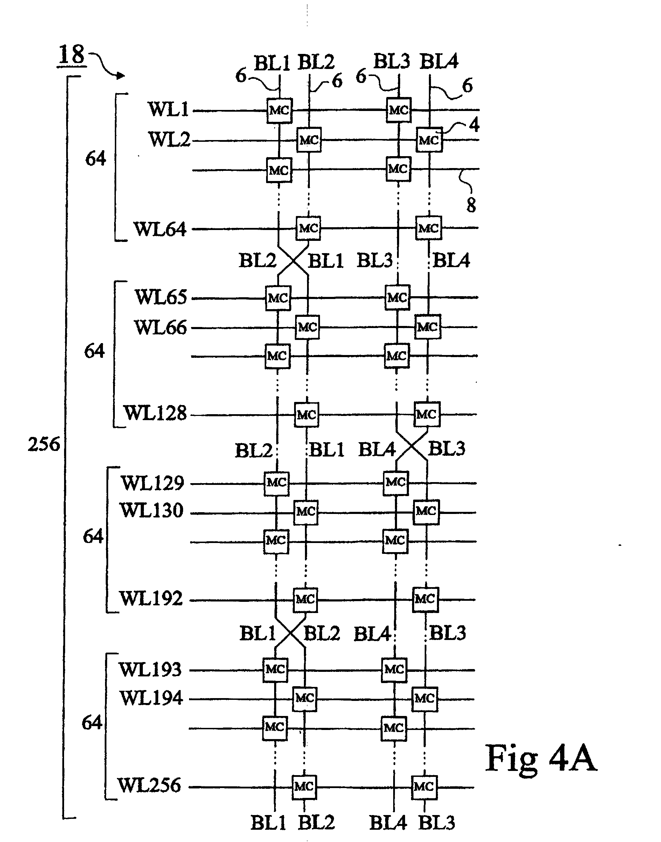

La figure 4A représente deux couples de lignes de bit (BL1, BL2 et BL3, BL4) d'une mémoire dynamique 18 à 256 rangées. Chaque ligne de bit est reliée à 128 cellules mémoire 4 (MC) disposées de manière alternée. En outre, suite aux croisements des lignes de bit, les rangées de la mémoire 18 sont agencées en quatre secteurs de 64 rangées chacun, correspondant respectivement aux rangées 1 à 64, 65 à 128, 129 à 192 et 193 à 256.

Dans le premier secteur, chaque rangée impaire comporte deux cellules mémoire adjacentes reliées respectivement aux lignes de bit BL1 et BL3 et chaque rangée paire comporte deux cellules mémoire adjacentes reliées respectivement aux lignes de bit BL2 et BL4. Les lignes de bit BL1 et BL2 sont croisées entre les rangées 64 et 65 de sorte que, dans le deuxième secteur, les cellules mémoire des rangées impaires sont reliées respectivement aux lignes de bit BL2, BL3, et les cellules mémoire des rangées paires sont reliées respectivement aux lignes de bit BL1, BL4. De même, les lignes BL3 et BL4 sont croisées entre les rangées 128 et 129. Enfin, les lignes BL1 et BL2 sont croisées entre les rangées 192 et 193. Chaque rangée est activable par une ligne de mot WL1 à WL256.

Certaines cellules mémoire 4 peuvent être défectueuses. Pour remplacer ces cellules défectueuses, on prévoit en général des cellules de secours organisées en rangées ou en colonnes. Lorsqu'une cellule défectueuse est repérée, on "remplace" la rangée ou la colonne où se trouve cette cellule par une rangée ou une colonne de secours. Cela est fait en modifiant le décodeur d'adresse de sorte qu'il adresse, à la place de la rangée ou de la colonne défectueuse, une rangée ou colonne de secours. Lorsque plusieurs cellules d'une même rangée sont défectueuses, c'est la rangée de ces cellules qui est "remplacée", ce qui élimine plusieurs défauts en une seule fois.

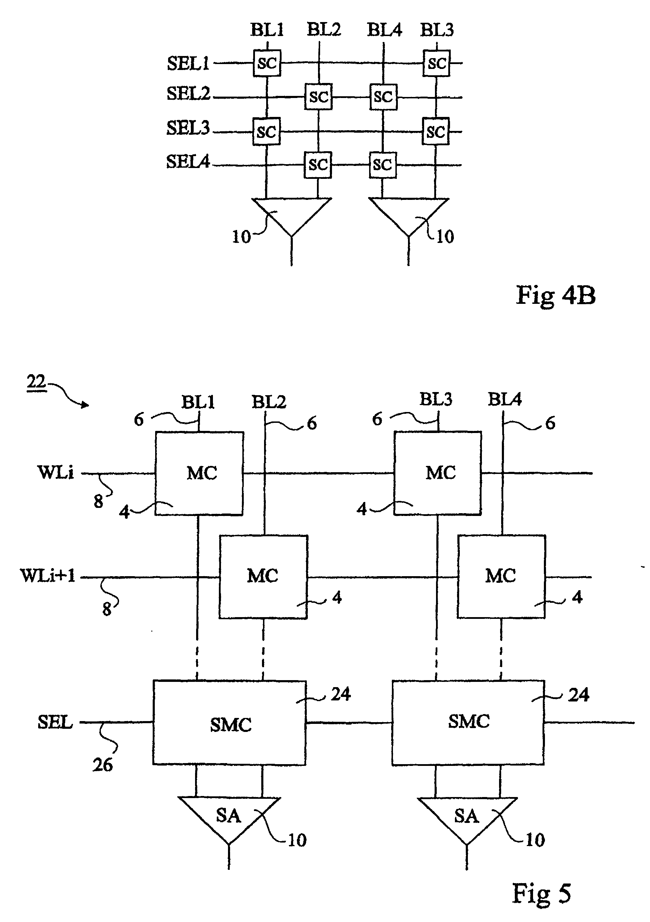

La figure 4B représente de manière schématique des rangées de cellules de secours SC destinées à remplacer une rangée défectueuse de la mémoire 18. Les lignes de bit BL1 à BL4 correspondent à l'extrémité des lignes de bit de la figure 4A. Comme il y a quatre types de rangées de cellules mémoire dans la mémoire 18, il est nécessaire de prévoir quatre rangées de secours pour remplacer une rangée quelconque de la mémoire. Lorsqu'une rangée de la mémoire 18 est défectueuse, on commence par déterminer le type de rangée dont il s'agit. Ensuite, on lui associe une rangée de secours prédéterminée, correspondant au type de la rangée à remplacer. Ainsi, par exemple, les rangées impaires du secteur 1 et les rangées paires du secteur 3 ont la même configuration que la première rangée de secours illustrée en figure 4B et seront remplacées par celle-ci. Ensuite, le décodeur d'adresse associera définitivement l'adresse de la rangée défectueuse à celle de la rangée de secours. Chaque rangée de secours est activée par une ligne d'activation, SELi, qui sera activée lors d'un adressage de la rangée.

Lorsque le nombre d'erreurs que l'on veut pouvoir corriger augmente, le nombre de rangées de secours devient important (d'autant plus qu'il faut prévoir quatre types de rangées de secours) et cela crée de nombreux problèmes. Ainsi, la présence de nombreuses rangées de secours, reliées aux lignes de bit, impose un rallongement significatif de ces dernières, ce qui affaiblit la variation de tension liée à la lecture d'une cellule d'une ligne de bit. Aussi, lorsqu'on accroît le nombre de rangées de secours, on accroît, pour des raisons statistiques, les risques qu'une cellule d'une rangée de secours elle-même soit défectueuse et la prévision de cellules de secours remplaçant d'éventuelles cellules de secours défectueuses risque de rendre le système compliqué et difficile à gérer. Les rangées de secours accroissent en outre la surface totale occupée par la mémoire, et son coût. Par ailleurs, l'étape qui consiste à remplacer une rangée contenant une cellule défectueuse par une rangée de secours est complexe, car elle demande d'identifier précisément le type de la rangée pour remplacer celle-ci par une rangée de secours appropriée prise parmi toutes les rangées de secours disponibles.

Le document JP 56 019595 décrit un circuit mémoire dans lequel les rangées de secours sont formées de cellules de mémoire statique reliées à des lignes de bit particulières. Celles-ci sont sélectionnées par l'intermédiaire d'un multiplexeur au lieu des lignes de données d'entrée/sortie de la partie dynamique de la mémoire lorsque l'adresse d'une rangée défectueuse est détectée.

Un objet de la présente invention est de prévoir, dans un circuit de mémoire, une structure de rangée de cellules mémoire de secours ayant une mise en oeuvre plus simple et plus efficace.

Un autre objet de la présente invention est de prévoir un tel circuit qui occupe une surface réduite par rapport aux circuits à cellules de secours classiques.

Pour atteindre ces objets, ainsi que d'autres, la présente invention prévoit un circuit de mémoire dynamique comprenant des cellules mémoire organisées en réseau de rangées et de colonnes, chaque rangée étant activable par une ligne de mot et chaque colonne étant formée de cellules reliées à une première et à une deuxième ligne de bit, qui comprend au moins une rangée de secours formée de cellules de mémoire statique, propre à être activée en remplacement d'une rangée de cellules mémoire, chaque cellule de secours étant reliée aux première et deuxième lignes de bit d'une colonne du circuit.

Selon un mode de réalisation de la présente invention, la rangée de cellules mémoire remplacée par la rangée de secours n'est pas adressée lors de l'adressage de la rangée de secours.

Selon un mode de réalisation de la présente invention, la rangée de cellules mémoire remplacée par la rangée de secours est adressée lors de l'adressage de la rangée de secours.

Selon un mode de réalisation de la présente invention, les lignes de bit se croisent au moins une fois.

Selon un mode de réalisation de la présente invention, le circuit de mémoire comprend en outre un amplificateur de lecture sur chaque colonne de la mémoire, les entrées de l'amplificateur étant respectivement reliées aux première et deuxième lignes de bit.

Selon un mode de réalisation de la présente invention, le circuit de mémoire comprend en outre des rangées de cellules d'ajustement de tension disposées soit entre les cellules mémoire de la mémoire et les cellules de secours soit entre les cellules de secours et les amplificateurs de lecture.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1A, précédemment décrite, représente de manière schématique une structure classique de mémoire dynamique ;
la figure 1B illustre l'allure des cellules de la figure 1A ;
la figure 2, précédemment décrite, illustre les tensions sur des lignes de bit lors de la lecture d'une cellule de la mémoire de la figure 1 ;
la figure 3, précédemment décrite, représente de manière schématique une autre structure classique de mémoire dynamique ;
la figure 4A, précédemment décrite, représente de manière schématique une autre structure classique de mémoire dynamique ;
la figure 4B, précédemment décrite, représente de manière schématique la disposition de rangées de secours de la structure de la figure 4A ;
la figure 5 représente de manière schématique une structure de mémoire dynamique selon la présente invention ;

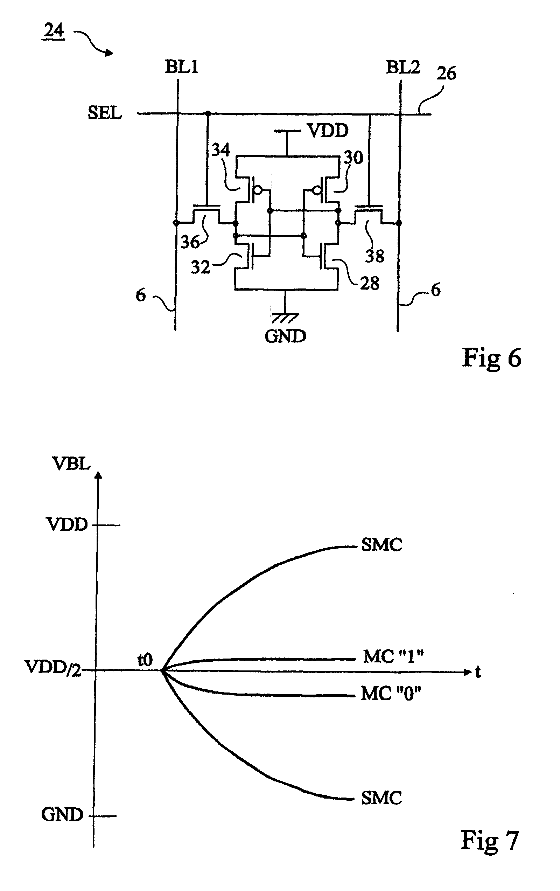

la figure 6 représente un mode de réalisation d'une cellule mémoire de secours utilisable dans la présente invention ; et
la figure 7 illustre les tensions sur des lignes de bit lors de la lecture d'une cellule mémoire de secours selon la présente invention.

Dans les figures, de mêmes références désignent de mêmes éléments. Seuls les éléments nécessaires à la compréhension de l'invention ont été représentés.

La figure 5 illustre un circuit de mémoire 22 comportant des cellules mémoire MC organisées en réseau de rangées et de colonnes. Chaque rangée est activable par une ligne de mot WL. Chaque colonne est constituée par des cellules mémoire 4 reliées à deux lignes de bit BL1 et BL2, reliées à un amplificateur de lecture 10. Quatre lignes de bit consécutives, BL1 à BL4, sont illustrées. La figure 5 illustre également une rangée de secours 26, commandée par une ligne de sélection SEL. Cette rangée de secours 26 est constituée de cellules de secours SMC reliées chacune aux deux lignes de bit d'une colonne, d'une part, et à l'amplificateur de lecture 10 de la colonne, d'autre part. Selon la présente invention, les cellules de secours SMC sont des cellules de mémoire statiques (SRAM). Chaque cellule 24 peut recevoir et stocker une donnée à partir de la première ou de la seconde ligne de bit de la colonne. En lecture, la cellule SMC portera la ligne de bit qui a servi pour son écriture à une tension correspondant à la donnée qu'elle emmagasine.

La cellule 24 peut remplacer une rangée défectueuse quelconque du circuit mémoire 22. Dans la figure 4B, le remplacement des lignes impaires du secteur 1 devait être fait à l'aide de la première rangée SEL1 de cellules de secours. Avec la structure de la figure 5, il suffira d'écrire dans la cellule 24 de la première colonne à l'aide de la ligne de bit BL1 et dans la cellule 24 de la deuxième colonne à l'aide de la ligne de bit BL3. De même, pour les rangées impaires du troisième secteur par exemple, ce serait dans l'art antérieur la deuxième rangée de cellules de secours SEL2 qui devrait être activée en remplacement de la rangée défectueuse. Dans le mode de réalisation de la présente invention, la même rangée de cellules SMC peut être utilisée pour remplacer aussi ce type de rangée défectueuse, il suffit simplement dans ce cas d'écrire dans la cellule 24 de la première colonne à l'aide de la ligne de bit BL1 et d'écrire dans la cellule 24 de la deuxième colonne à l'aide de la rangée de bit BL4. Par conséquent, une seule rangée de cellules de secours 24 suffit pour remplacer une rangée quelconque de la mémoire dynamique. Cela est particulièrement avantageux dans un cas comme celui de la figure 4A, où il faut prévoir quatre rangées de secours pour pouvoir remplacer une quelconque rangée de la mémoire.

Si l'on souhaite remplacer plusieurs rangées défectueuses, il suffira de prévoir autant de rangées de secours que de rangées à remplacer, ce qui augmente la longueur des lignes de bit de façon limitée.

Un autre avantage d'utiliser des cellules de mémoire statique 24 comme cellules de secours est que, lors de leur lecture, de telles cellules fournissent aux lignes de bit des niveaux de tension nettement supérieurs aux niveaux fournis par les cellules DRAM de secours classique, comme cela va être vu ci-après.

Lorsque, au cours d'une étape de test, une cellule 4 défectueuse est détectée, une opération de réparation consiste à reprogrammer le décodeur d'adresse de rangée (non représenté) pour qu'il associe définitivement l'adresse de la rangée contenant la cellule défectueuse à une rangée de secours. Cette opération de reprogrammation du décodeur d'adresse est ici particulièrement simple par le fait qu'une rangée de secours selon la présente invention peut remplacer n'importe quelle rangée défectueuse, quelle que soit sa parité ou le secteur où elle se trouve. Une telle modification du décodeur d'adresse est à la portée de l'homme de l'art et ne sera pas décrite plus avant.

Comme cela vient d'être décrit, une seule rangée de secours selon la présente invention permet en général de remplacer plusieurs rangées de secours classiques (deux si la mémoire a des cellules alternées sans croisement de lignes de bit, quatre si la mémoire est du type de la mémoire 18) et il s'ensuit en général un gain dans la surface occupée par la mémoire. D'autre part, comme une rangée de secours peut être utilisée pour remplacer une rangée défectueuse quelconque, du circuit de mémoire, la mise en oeuvre des rangées de secours selon la présente invention est particulièrement simple.

La figure 6 représente le schéma d'un exemple de cellule de secours 24 de type SRAM utilisable dans la présente invention. La cellule 24 comporte un premier couple de transistors formé d'un transistor MOS de type N 28 et d'un transistor MOS de type P 30 et un second couple de transistors formé d'un transistor MOS de type N 32 et d'un transistor MOS de type P 34. Les premier et second couples de transistors sont connectés de manière à former respectivement un premier et un deuxième inverseurs alimentés chacun par la tension d'alimentation et la masse, respectivement VDD et GND. L'entrée du premier inverseur, reliée à la sortie du deuxième inverseur, est également reliée par l'intermédiaire d'un transistor MOS de type N 36, à la ligne de bit BL1. L'entrée du deuxième inverseur, reliée à la sortie du premier inverseur, est également reliée par l'intermédiaire d'un transistor MOS de type N, 38, à la ligne de bit BL2. Les grilles des transistors 36 et 38 sont reliées à la ligne de sélection 26. Le fonctionnement de la cellule 24, connu, ne sera pas décrit ici.

La figure 7 illustre les tensions présentes sur les lignes de bit BL1 ou BL2 lors de la lecture de la cellule 24 de la figure 6. Ces tensions correspondent aux tensions d'alimentation VDD et GND. Ainsi, quelle que soit l'information ("1" ou "0") stockée dans la cellule 24, une des lignes de bit est sensiblement amenée à la masse GND et l'autre des lignes de bit est sensiblement amenée à la tension VDD lors de la lecture de la cellule 24. Cela est illustré par les courbes SMC de la figure 7.

En figure 7, sont également représentées de manière schématique les tensions mises en jeu lors de la lecture d'une information "1" (référence MC"1") ou "0" (référence MC"0") d'une cellule de secours classique à structure DRAM.

Lorsqu'une rangée contient une ou plusieurs cellules défectueuses et qu'elle est remplacée, le décodeur d'adresse de rangée est programmé pour qu'il associe définitivement l'adresse de la rangée défectueuse à l'adresse d'une rangée de secours. On peut alors inactiver la rangée contenant la cellule défectueuse lors d'une lecture ou écriture de la rangée de secours. Cependant, vu la nette différence des niveaux de tension présentés par les cellules de secours selon la présente invention et les cellules de la mémoire, il est possible, selon la présente invention, de ne pas inactiver la rangée défectueuse lors d'une utilisation de la rangée de secours. Chaque cellule de la rangée défectueuse doublée sera alors écrite et lue en parallèle avec une cellule de secours. Si la valeur stockée dans la cellule défectueuse ne correspond pas à la valeur stockée dans la cellule de secours correspondante, la faible variation de tension produite en lecture par la cellule défectueuse sera masquée par la tension fournie par la cellule de secours et cela n'aura aucune incidence sur la valeur lue. Une telle variante permet de simplifier le décodeur d'adresse, qui n'a plus besoin d'inactiver la rangée contenant une cellule défectueuse lorsqu'il associe son adresse à celle d'une rangée de secours.

En outre, pour la même raison, si la mémoire possède des cellules d'ajustement de tension 14, leur activation ou inactivation lors de la lecture d'une cellule de secours selon la présente invention n'aura aucune influence sur la valeur lue.

Bien entendu, la présente invention est susceptible de diverses variantes et modifications qui apparaîtront à l'homme du métier.

Par exemple, on a représenté en figure 6 une cellule SRAM 24 comportant six transistors, mais l'homme du métier adaptera sans difficultés la présente invention à des cellules SRAM de taille plus réduite, par exemple comportant quatre transistors, en particulier dans le cas où la tension de précharge est VDD.

Par ailleurs, bien que l'invention soit particulièrement avantageuse dans le cas d'une mémoire du type de la mémoire 18, avec croisements de lignes de bit, la présente invention présente aussi des avantages dans le cas où les lignes de bit ne sont pas croisées car, du fait de la disposition alternée des cellules mémoire, deux rangées de secours sont nécessaires dans l'art antérieur pour remplacer une quelconque rangée défectueuse, alors que la présente invention ne nécessite qu'une rangée de secours.

## Revendications

1. Circuit de mémoire dynamique (22) comprenant des cellules mémoire (4) organisées en réseau de rangées et de colonnes, chaque rangée étant activable par une ligne de mot (WLi) et chaque colonne étant formée de premières et de deuxièmes cellules reliées à une première et à une deuxième ligne de bit, respectivement, ledit circuit comprenant au moins une rangée de secours formée de cellules de mémoire statique (24), propre à être activée en remplacement d'une rangée de cellules mémoire, ledit circuit étant **caractérisé en ce que** chaque cellule de secours est reliée aux première et deuxième lignes de bit d'une colonne du circuit (22).

2. Circuit de mémoire selon la revendication 1, dans lequel la rangée de cellules mémoire remplacée par la rangée de secours n'est pas adressée lors de l'adressage de la rangée de secours.

3. Circuit de mémoire selon la revendication 1, dans lequel la rangée de cellules mémoire remplacée par la rangée de secours est adressée lors de l'adressage de la rangée de secours.

4. Circuit de mémoire selon l'une quelconque des revendications précédentes, dans lequel pour chaque colonne les lignes de bit se croisent au moins une fois.

5. Circuit de mémoire selon l'une quelconque des revendications précédentes, comprenant en outre un amplificateur de lecture (10) sur chaque colonne de la mémoire (22), les entrées de l'amplificateur étant respectivement reliées aux première et deuxième lignes de bit.

6. Circuit de mémoire selon la revendication 5, comprenant en outre des rangées de cellules d'ajustement de tension (14) disposées soit entre les cellules mémoire (4) de la mémoire (22) et les cellules de secours (24) soit entre les cellules de secours (24) et les amplificateurs de lecture (10).

## Patentansprüche

1. Eine dynamische Speicherschaltung (22), die Speicherzellen (4) aufweist, die in einer Anordnung von Reihen und Spalten angeordnet sind, wobei eine jede Reihe aktivierbar ist durch eine Wortleitung (WLi) und jede Spalte gebildet ist aus ersten und zweiten Zellen, die jeweils mit einer ersten und mit einer zweiten Bitleitung verbunden sind, wobei die Schaltung zumindest eine Ersatzreihe gebildet aus statischen Speicherzellen (24) aufweist, die angepasst sind für ein Aktivieren zum Ersetzen einer Speicherzellenreihe, wobei die Schaltung **gekennzeichnet ist dadurch**, dass jede Ersatzzelle mit den ersten und zweiten Bitleitung einer Spalte der Schaltung (22) verbunden ist.

2. Speicherschaltung nach Anspruch 1, wobei die Speicherzellenreihe, die durch die Ersatzreihe ersetzt wird, beim Adressieren der Ersatzreihe nicht adressiert wird.

3. Speicherschaltung nach Anspruch 1, wobei die durch die Ersatzreihe ersetzte Speicherzellenreihe beim Adressieren der Ersatzreihe adressiert wird.

4. Speicherschaltung nach einem der vorhergehenden Ansprüche, wobei für jede Spalte sich die Bitleitungen mindestens einmal kreuzen.

5. Speicherschaltung nach einem der vorhergehenden Ansprüche, die weiter einen Abfühlverstärker (10) auf jeder Speicherspalte (22) aufweist, wobei die Eingänge des Verstärkers jeweils mit den ersten und zweiten Bitleitungen verbunden sind.

6. Speicherschaltung nach Anspruch 5, die ferner eine Reihe von Spannungseinstellzellen (14) aufweist, die entweder zwischen den Speicherzellen (4) des Speichers (22) und den Ersatzzellen (24) oder zwischen den Ersatzzellen (24) und den Abfühlverstärkern (10) angeordnet sind.

## Claims

1. A dynamic memory circuit (22) including memory cells (4) arranged in an array of rows and columns, each row being activable by a word line (WLi) and each column being formed of first and second cells respectively connected to a first and to a second bit line, said circuit comprising at least one spare row formed of static memory cells (24), adapted to being activated to replace a memory cell row, said circuit being **characterized in that** each spare cell is connected to the first and second bit lines of a column of the circuit (22).

2. The memory circuit of claim 1, wherein the memory cell row replaced by the spare row is not addressed upon addressing the spare row.

3. The memory circuit of claim 1, wherein the memory cell row replaced by the spare row is addressed upon addressing the spare row.

4. The memory circuit of any of the preceding claims, wherein, for each column, the bit lines cross at least once.

5. The memory circuit of any of the preceding claims, further including a sense amplifier (10) on each memory column (22), the inputs of the amplifier being respectively connected to the first and second bit lines.

6. The memory circuit of claim 5, further including rows of voltage adjustment cells (14) arranged either between the memory cells (4) of the memory (22) and the spare cells (24) or between the spare cells (24) and the sense amplifiers (10).
